# EUROPEAN PATENT SPECIFICATION

(11) **EP 1 522 607 B1**
(45) Date of publication and mention of the grant of the patent: **14.06.2006**
(21) Application number: 04256177.9
(22) Date of filing: 06.10.2004
(51) Int. Cl.: C23C 14/06, C23C 14/16, C23C 14/30

(54) **Method for fabricating a coated superalloy stabilized against the formation of secondary reaction zone**
Verfahren zur Herstellung eines beschichtetes Substrats aus Superlegierung stabilisiert gegen die Bildung einer sekundären Reaktionszone
Procédé pour revêtir un substrat en super alliage afin de le stabiliser contre la formation d'une zone de réaction secondaire

(30) Priority: 07.10.2003 US 680697
(43) Date of publication of application: 13.04.2005
(73) Proprietor: GENERAL ELECTRIC COMPANY, Schenectady, NY 12345 (US)
(72) Inventor: Darolia, Ramgopal, West Chester, OH 45069 (US)
(74) Representative: Pedder, James Cuthbert

(56) References cited:
- EP-A- 0 545 661
- US-A- 4 117 179
- US-A1- 2003 044 634

## Description

This invention relates to a superalloy that is susceptible to the formation of a secondary reaction zone when coated with an aluminum-containing coating of a protective system and, more particularly, to the inhibition of the formation of the secondary reaction zone.

In an aircraft gas turbine (jet) engine, air is drawn into the front of the engine, compressed by a shaft-mounted compressor, and mixed with fuel. The mixture is combusted, and the resulting hot combustion gases are passed through a turbine mounted on the same shaft. The flow of hot combustion gas turns the turbine by contacting an airfoil portion of the turbine blade, which turns the shaft and provides power to the compressor. The hot exhaust gases flow from the back of the engine, driving it and the aircraft forward. There may additionally be a bypass fan that forces air around the center core of the engine, driven by a shaft extending from the turbine section.

The higher the temperature of the hot combustion gas, the greater the efficiency of the engine. There is therefore an incentive to operate the materials of the engine at ever-higher temperatures and loadings. A variety of techniques have been used to achieve higher temperatures, including, for example, improved alloy compositions, employment of oriented and single crystal turbine blades, thermal barrier coatings that provide environmental protection and act as insulation applied to the turbine blades, and physical cooling techniques. Nickel-based superalloys are widely used as the materials of construction of gas turbine blades and vanes.

One type of coating applied to the surface of the nickel-base superalloy is an aluminum-containing overlay coating. The aluminum in the coating oxidizes to form an aluminum oxide surface coating during treatment or in service. The aluminum oxide surface coating renders the coated article more resistant to oxidation and corrosion, desirably without impairing its mechanical properties. An insulating ceramic thermal barrier coating may be applied overlying the aluminum-containing coating.

Recently it has been observed that, when some advanced nickel-based superalloys, especially those containing high rhenium contents, are coated with an aluminum-containing coating and then exposed to service or simulated-service conditions, a secondary reaction zone (SRZ) forms in the underlying superalloy. This SRZ region is observed at a depth of from about 50 to about 250 micrometers (about 0.002-0.010 inches) below the original superalloy surface that has received the aluminide coating. The presence of the SRZ reduces the mechanical properties in the affected region, because the material in the SRZ is weak.

The formation of the SRZ is a major problem in some types of turbine components, because there are cooling channels located about 500-750 micrometers (about 0.020-0.030 inches) or less below the surface of the article. Cooling air is forced through the channels during operation of the engine, to cool the structure. If the SRZ forms in the region between the surface and the cooling channel, it may significantly weaken a major portion of the thickness of the turbine blade in that region and can lead to reduced strength and fatigue resistance of the article.

Several techniques have been proposed to reduce or avoid the formation of SRZ. However, none has been fully satisfactory, and there is always a need for an improved approach to reducing or avoiding the incidence of SRZ in advanced nickel-base superalloys. The present invention fulfills this need, and further provides related advantages.

The present invention provides an improved approach for preparing a superalloy article having an aluminum-containing coating thereon. The superalloy is potentially susceptible to the formation of an SRZ when coated with an aluminum-containing coating. With the present approach, the formation of the SRZ is reduced and, desirably, eliminated.

According to the invention, a method for preparing a coated superalloy article comprises the steps of furnishing a nickel-base superalloy substrate having a composition which, when interdiffused with aluminum, forms a secondary reaction zone, and thereafter applying a protective coating structure to a surface of the nickel-base superalloy substrate. The step of applying includes the steps of placing the nickel-base superalloy substrate into a deposition apparatus, thereafter depositing a carbon-containing layer overlying and contacting the surface of the nickel-base superalloy substrate, and thereafter depositing an aluminum-containing layer overlying and contacting the carbon-containing layer. The step of depositing the aluminum-containing layer is performed in the same deposition apparatus as the step of depositing the carbon-containing layer and without exposing the nickel-base superalloy substrate to an ambient atmospheric condition.

Typically, the substrate has at least about 4 weight percent rhenium, leading to an SRZ-susceptible composition, although in some cases nickel-base superalloys with less than about 4 weight percent rhenium may exhibit SRZ formation in some circumstances. A composition of interest, known in the industry as MX4 alloy, has a nominal composition, in weight percent, of about 16.5 percent cobalt, about 2 percent chromium, about 5.55 percent aluminum, about 8.25 percent tantalum, about 6 percent tungsten, about 5.95 percent rhenium, about 3 percent ruthenium, about 2 percent molybdenum, about 0.03 percent carbon, about 0.15 percent hafnium, about 0.004 percent boron, about 0.01 percent yttrium, balance nickel and minor elements.

The deposition apparatus is preferably a vacuum deposition apparatus. A deposition apparatus of interest is an electron-beam physical vapor deposition apparatus. Examples of other deposition apparatus include sputtering apparatus and ion-plasma deposition apparatus.

The carbon-containing layer may be deposited as substantially pure carbon, or it may be somewhat impure. The carbon is deposited in a form that is not a metallic carbide. Desirably, the carbon-containing layer is deposited to a thickness of from about 5 to about 15 micrometers, more preferably from about 7.5 to about 15 micrometers.

The aluminum-containing layer is preferably an overlay coating. The aluminum-containing is most preferably a nickel aluminide overlay coating or an MCrAIX overlay coating.

After the aluminum-containing layer is deposited, the substrate with the carbon-containing layer and the aluminum-containing layer thereon is preferably heat treated at a temperature greater than about 1800°F. There is typically some interdiffusion of the carbon-containing layer with the substrate when the carbon-containing layer is deposited at elevated temperature, but this separate heat treatment achieves a greater degree of interdiffusion of the carbon atoms into the near-surface region of the substrate. The carbon from the carbon-containing layer forms carbides with the refractory metals in the substrate superalloy. The availability of these refractory metals in solution to form the SRZ is reduced, thereby reducing the incidence of SRZ in the subsurface region of the substrate.

Optionally, a ceramic layer is deposited overlying and contacting the aluminum-containing layer, either before or after the optional heat treating is performed. In one embodiment, the step of depositing the ceramic layer is performed in the same deposition apparatus as the step of depositing the carbon-containing layer and the step of depositing the aluminum-containing layer, and without exposing the nickel-base superalloy substrate to an ambient atmospheric condition. In another embodiment, the step of depositing the ceramic layer is performed in a different deposition apparatus than are the step of depositing the carbon-containing layer and the step of depositing the aluminum-containing layer.

Thus, in a preferred approach, a method for preparing a coated superalloy article comprises the steps of furnishing a nickel-base superalloy substrate containing elements which, when interdiffused with aluminum, form a secondary reaction zone. The nickel-base superalloy substrate has at least about 4 weight percent rhenium. A protective coating structure is thereafter applied to a surface of the nickel-base superalloy substrate. The step of applying includes the steps of placing the nickel-base superalloy substrate into a vacuum deposition apparatus and evacuating the vacuum deposition apparatus, thereafter vacuum depositing a carbon-containing layer to a thickness of from about 5 to about 15 micrometers overlying and contacting the surface of the nickel-base superalloy substrate, and thereafter vacuum depositing an aluminum-containing layer overlying and contacting the carbon-containing layer. The step of depositing the aluminum-containing layer is performed in the same deposition apparatus as the step of depositing the carbon-containing layer and without exposing the nickel-base superalloy substrate to an ambient atmospheric condition. The method includes thereafter vacuum heat treating the substrate with the carbon-containing layer and the aluminum-containing layer thereon at a temperature greater than about 1800°F.

The present approach requires that the deposition of the carbon-containing layer and the deposition of the aluminum-containing layer be performed in the same deposition apparatus. The carbon-containing layer (which also typically contains some interdiffused metal from the substrate) is not exposed to the ambient atmosphere after it is deposited but before the aluminum-containing layer is deposited. If the carbon-containing layer is exposed to the ambient atmosphere before the aluminum-containing layer is deposited, the resulting oxide and contamination must be removed before the aluminum-containing layer may be deposited. The removal of oxide and contamination is typically performed by shot blasting or grit blasting. Shot blasting and grit blasting tend to implant small amounts of the grit and contamination in the surface. Even a small amount of this foreign matter has a disproportionate effect on the final properties, because it interferes with the desirable diffusion. The result would be an undesirable surface state for the deposition of the aluminum-containing layer, and potentially to the removal of the carbon-containing layer, if used as part of the present approach. In the present approach, there is no opportunity for oxide or contamination to reach the surface of the carbon-containing layer prior to the time that the aluminum-containing layer is deposited, and therefore no cleaning (either chemical cleaning or physical cleaning such as shot blasting or grit blasting) is used between the steps of depositing the carbon-containing layer and depositing the aluminum-containing layer. The result is improved performance in the final coated superalloy article, as compared with an alternative approach wherein the carbon-containing layer and the aluminum-containing layer are deposited in separate apparatus and there is exposure of the carbon-containing layer to the ambient atmosphere.

The invention will now be described in greater detail, by way of example, with reference to the drawings, in which:-
Figure 1 is a perspective view of a gas turbine blade;
Figure 2 is an enlarged schematic sectional view of the gas turbine blade of Figure 1, taken along line 2-2, in a case where the SRZ is allowed to form;
Figure 3 is a block flow diagram of an embodiment of a preferred approach for practicing the invention;
Figure 4 is an enlarged schematic sectional view of the gas turbine blade of Figure 1, taken along line 2-2, where the present approach is used to inhibit SRZ formation and after deposition of the carbon-containing layer; and.
Figure 5 is an enlarged schematic sectional view of the gas turbine blade of Figure 1, taken along line 2-2, where the present approach is used to inhibit SRZ formation and after the interdiffusion heat treat.

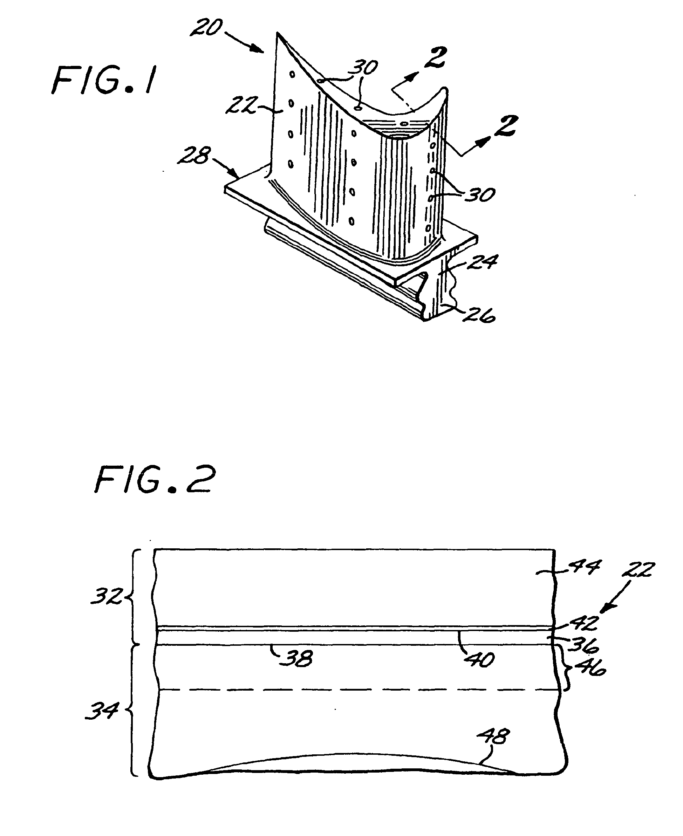

Figure 1 depicts a nickel-base superalloy article 18 in the form of a gas turbine blade 20 having an airfoil 22 against which a flow of hot combustion gas impinges during service operation. The gas turbine blade 20 also includes a downwardly extending shank 24, and an attachment in the form of a dovetail 26 which attaches the gas turbine blade 20 to a gas turbine disk (not shown) of the gas turbine engine. A platform 28 extends transversely outwardly at a location between the airfoil 22, on the one hand, and the shank 24 and dovetail 26, on the other hand. The airfoil 22 is hollow, with internal cooling passages extending from openings (not shown) in the bottom of the dovetail 26, through the interior of the airfoil 22, and to openings 30 in the lateral surface of the airfoil 22 and at the tip end of the airfoil 22. During service, relatively cool air is forced under pressure through the internal cooling passages and out the openings 30. The cool air removes heat from the airfoil 22 of the gas turbine blade 20, allowing it to run in hotter combustion gas than would otherwise be the case.

Figure 2 is a sectional view of the airfoil 22, in a case where the present approach is not used to reduce SRZ formation. (Figures 2, 4, and 5 are not drawn to scale.) A protective coating structure 32 is applied to the surface of the airfoil 22, which serves as a substrate 34 for the protective coating structure 32. The protective coating structure 32 typically includes an aluminum-containing layer 36, which is applied to the surface 38 of the substrate 34. An upper-surface 40 of the aluminum-containing layer 36 subsequently oxidizes to form a thin aluminum oxide protective scale 42 that inhibits further oxidation. A ceramic layer 44 that serves as a thermal barrier coating is optionally applied overlying the aluminum-containing layer 36 to provide thermal insulation against the hot combustion gas.

Where the nickel-base superalloy of the substrate 34 is an alloy that is susceptible to the formation of SRZ when interdiffused with the aluminum-containing layer 36, the interdiffusion of the aluminum-containing layer 36 with the substrate 34, during processing and/or service, results in the formation of a secondary reaction zone (SRZ) 46. The formation of SRZ in these circumstances is well documented and described, for example, in US Patents 5,334,263; 5,455,120; 5,695,821; and 6,447,932, whose disclosures are incorporated by reference. The SRZ 46 typically extends to a depth of from about 50 to about 250 micrometers (about 0.002-0.010 inches) below the surface 38 of the substrate 34. The SRZ 46 is relatively brittle and weak as compared with the original superalloy that forms the substrate 34.

A portion of one of the cooling passages 48 is also seen in Figure 2. Depending upon the design, the cooling passage 48 may have a closest approach to the surface 38 of from about 500 to about 750 micrometers (about 0.020 to about 0.030 inches). Thus, as schematically illustrated, even though the SRZ 46 is relatively thin, its presence may degrade the properties of the substrate 34 through a substantial portion--as much as 1/2 to 1/3-of the wall thickness between the wall of the cooling passage 48 and the surface 38 of the substrate 34. The undesirable presence of even the thin SRZ 46 therefore presents a major concern when the airfoil 22 is made of the SRZ-susceptible superalloy composition, because the SRZ has reduced mechanical properties as compared with the bulk substrate 34.

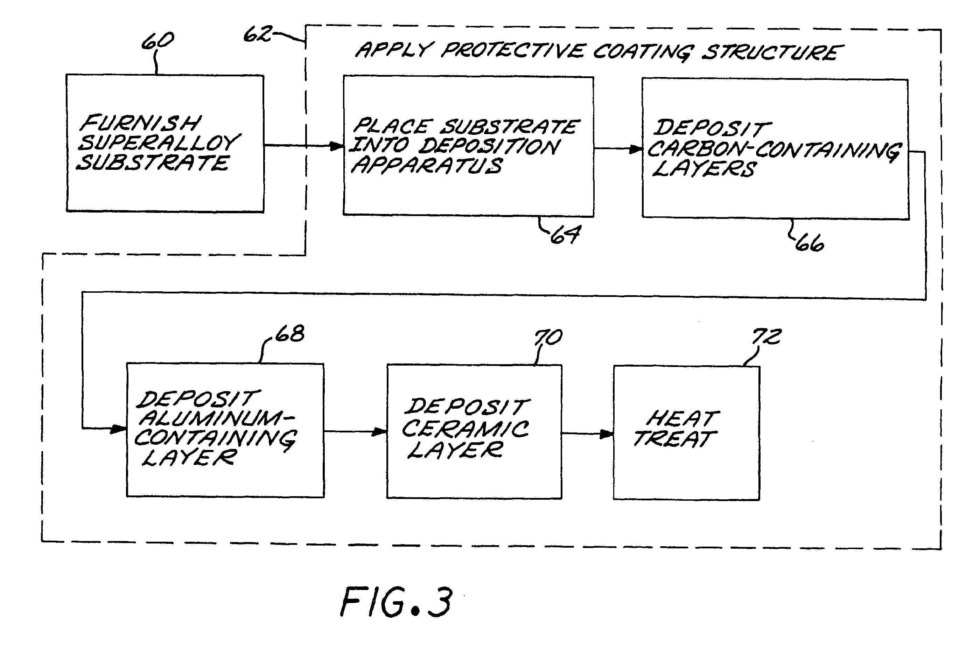

Figure 3 illustrates in block diagram form a preferred approach for preparing a coated superalloy article that reduces, and desirably eliminates, the incidence of SRZ formation in an SRZ-susceptible superalloy. The method includes furnishing, step 60, a nickel-base superalloy substrate having a composition which, when interdiffused with aluminum, forms a secondary reaction zone. Not all nickel-base superalloys are subject to the formation of SRZ. Those subject to SRZ formation may be determined experimentally by coating the alloy in the manner depicted in Figure 2, and assessing from the microstructure and/or the physical properties whether there is SRZ formation. In general, however, the alloys that are most susceptible to SRZ formation are those containing at least about 4 weight percent rhenium, although some nickel-base superalloys with less than about 4 weight percent rhenium have exhibited SRZ formation in some circumstances. A nickel-base superalloy composition of particular interest and SRZ susceptibility, known as MX4 alloy, has a nominal composition, in weight percent, of about 16.5 percent cobalt, about 2 percent chromium, about 5.55 percent aluminum, about 8.25 percent tantalum, about 6 percent tungsten, about 5.95 percent rhenium, about 3 percent ruthenium, about 2 percent molybdenum, about 0.03 percent carbon, about 0.15 percent hafnium, about 0.004 percent boron, about 0.01 percent yttrium, balance nickel and minor elements. The substrate 34 is desirably furnished in substantially the final form of the article of interest, such as the gas turbine blade 20.

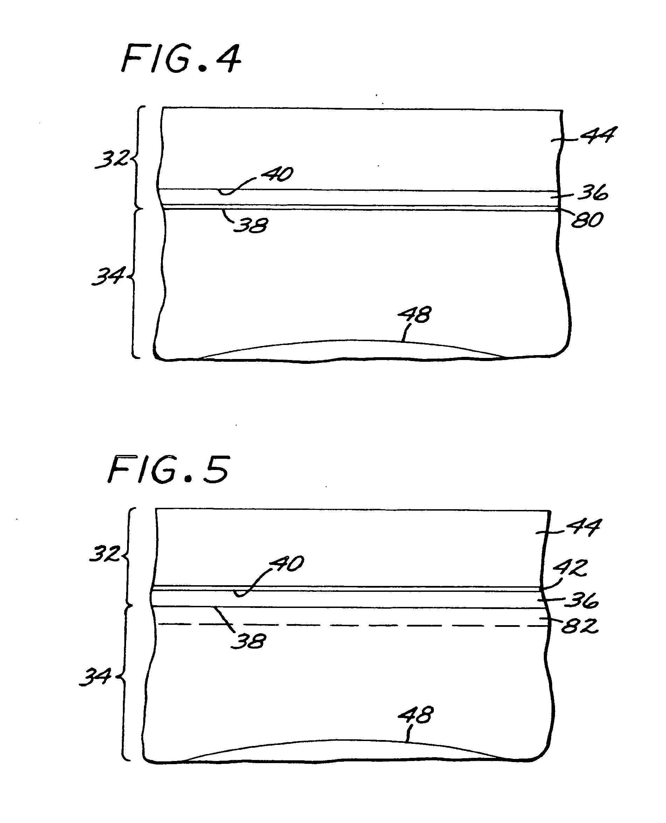

The protective coating structure 32 is thereafter applied to the surface 38 of the nickel-base superalloy substrate 34, step 62, by a multistep process. Figure 4 illustrates the protective coating structure 32 at an intermediate stage of the preferred application process 62. The nickel-base superalloy substrate 34 is first placed into a deposition apparatus, step 64. The deposition apparatus is preferably a vacuum deposition apparatus. A preferred vacuum deposition apparatus is an electron-beam physical vapor deposition (EB-PVD) apparatus. Other operable deposition apparatus include, for example, magnetron sputtering apparatus and ion-plasma deposition apparatus. Such deposition apparatus is known in the art for other applications and is available commercially. The deposition apparatus is supplied with the starting materials that are required for the subsequent deposition operations.

A carbon-containing layer 80 is thereafter deposited overlying and contacting the surface 38 of the nickel-base superalloy substrate 34, step 66. The carbon-containing layer 80 is preferably substantially pure carbon, but it may be a carbon-containing mixture. Preferably, however, the carbon is deposited in a form that is not chemically reacted with another element, such as a metallic carbide. Fine metallic carbide particles are formed after deposition of the carbon by a chemical reaction between the deposited carbon and the refractory metallic elements in the nickel-base superalloy that forms the substrate 34. If the carbon were deposited in an already-reacted form, it would not be available for this subsequent chemical reaction. The carbon-containing layer is preferably deposited to a thickness of from about 5 to about 15 micrometers, more preferably from about 7.5 to about 15 micrometers, to provide a sufficient layer for completely or largely avoiding the SRZ.

The aluminum-containing layer 36 is deposited, step 68, overlying and contacting the carbon-containing layer 80. The step 68 of depositing the aluminum-containing layer 36 is performed in the same deposition apparatus as the step 66 of depositing the carbon-containing layer 80. The step 68 is performed without exposing the nickel-base superalloy substrate 34 to an ambient atmospheric condition, either during the step 68 or between the steps 66 and 68. (As used herein, "ambient atmosphere" refers to the normal one-atmosphere-pressure environment in which we live.) That is, where the deposition steps are performed in a vacuum deposition apparatus, the vacuum is not broken between the beginning of step 66 and the end of step 68, thereby exposing the substrate to air, with its associated oxidation and contamination. As used herein, "same deposition apparatus" and the like includes, but is not limited to, the cases where the carbon-containing layer 80 and the aluminum-containing layer 36 are deposited using the same type of source in the same chamber, the carbon-containing layer 80 and the aluminum-containing layer 36 are deposited using different types of sources but in the same chamber, the carbon-containing layer 80 and the aluminum-containing layer 36 are deposited using the same type of source in different chambers that are interconnected in a manner so that the substrate is never exposed to the ambient atmosphere when it is moved between the chambers, and the carbon-containing layer 80 and the aluminum-containing layer 36 are deposited using different types of sources in different chambers that are interconnected in a manner so that the substrate is never exposed to the ambient atmosphere when it is moved between the chambers.

The aluminum-containing layer 36 is preferably an overlay coating that is complete without the need for substantial diffusion of elements from the substrate 34 into the aluminum-containing layer 36. The overlay coating of the aluminum-containing layer 36 is preferred because the carbon-containing layer 80, and the interdiffusion zone between the carbon-containing layer 80 and the substrate 34, serve as at least partial diffusion barriers to interdiffusion between the substrate 34 and the aluminum-containing layer 36.

The most preferred aluminum-containing layers 36 are either a predominantly beta phase nickel aluminide overlay coating having a nominal composition in atomic percent of 30 to 60 percent aluminum, 2 to 15 percent chromium, 0.1-1.2 percent zirconium, balance nickel; or an MCrAIX overlay coating having a nominal composition in weight percent of 12-18 percent aluminum, up to 30 percent cobalt, 10-25 percent chromium, 0.1-1.0 percent yttrium, balance nickel. These overlay coatings may be deposited from a pre-alloyed ingot, or from multiple sources of the various elements that deposit the net composition of the overlay coating.

Optionally, the ceramic layer 44 may be deposited overlying and contacting the aluminum-containing layer 36, step 70. The ceramic layer may be deposited by any operable approach. In one embodiment, the step 70 of depositing the ceramic layer 44 is performed in the same deposition apparatus as the step 66 of depositing the carbon-containing layer 80 and the step 68 of depositing the aluminum-containing layer 36. In this case, the ceramic deposition step 70 is performed without exposing the nickel-base superalloy substrate 34 to an ambient atmospheric condition, from the beginning of step 66, including step 68, and to the end of step 70. In another embodiment, the step 70 of depositing the ceramic layer 44 is performed in a different deposition apparatus than the step 66 of depositing the carbon-containing layer 80 and the step 68 of depositing the aluminum-containing layer 36.

The deposition step 66 of the carbon-containing layer 80 and the deposition step 68 of the aluminum-containing layer 36 are typically performed at an elevated temperature, typically from about 1800°F to about 2000°F. However, the temperatures and times depend upon the type of deposition apparatus that is used. At these elevated temperatures, there is some interdiffusion of the carbon-containing layer 80 with the adjacent portion of the substrate 34 during the deposition steps 66 and 68. This interdiffusion results in the chemical reaction of the carbon and the refractory elements such as rhenium, chromium, tantalum and tungsten in the substrate 34, reducing the amount of these elements available to react to form the undesirable SRZ. The result is a carbide-containing interdiffusion zone 82 shown in Figure 5.

However, the interdiffusion that occurs in steps 66 and 68 may be insufficient to produce the desired extent of the interdiffusion zone 82, which desirably extends a depth of about 5-10 micrometers into the substrate 34 from the substrate surface 38. To increase the extent of the interdiffusion zone 82 (i.e., its depth below the substrate surface 38), the substrate 34 with the carbon-containing layer and the aluminum-containing layer thereon are heat treated, step 72, at a temperature greater than about 1800°F, preferably from about 1900°F to about 2100°F. A preferred interdiffusion heat treatment 72 is at 2000°F for a time of 2 hours. Where the optional ceramic deposition step 70 is performed, the heat treatment step 72 may be performed before, concurrently with, or after the step 70. Further interdiffusion occurs during the service of the coated article.

The upper surface 40 of the aluminum-containing layer 36 is oxidized to form the aluminum oxide protective scale 42 either during the deposition and heat treatment steps, by a separate step during processing, or after the coated article is introduced into service. The partial pressure of oxygen required to achieve the oxidation is low, so that the necessary oxidation may occur even during vacuum processing.

The present invention has been reduced to practice using the preferred approach of Figure 3 and as discussed above. Specimens prepared by the present approach were comparatively tested against baseline specimens to which no carbon-containing layer was applied (as in Figure 2), and specimens having a carbon layer prepared by the approach of US Patent 5,334,263. The specimens were prepared with an MX4 substrate alloy, a carbon-containing layer overlying the substrate where appropriate, a nickel aluminide layer overlying and contacting the substrate (if no carbon-containing layer is present) or the carbon-containing layer (where present), and a thermal barrier coating of yttria-stabilized zirconia overlying and contacting the nickel aluminide layer (and any aluminum oxide scale that had already formed). Baseline specimens were prepared in an otherwise identical manner but without any deposited carbon-containing layer.

In a first comparative test, furnace cycle testing was conducted in repeated one-hour cycles of a 5-8 minute heat up, 45 minutes at 2125°F, and a 7-10 minute cooldown to room temperature. Specimens prepared by the present approach had an average lifetime of 393 cycles before failure, whereas specimens prepared by the approach of the '263 patent had an average lifetime of 170 cycles.

In a second comparative test, specimens were tested in stress rupture loading. In a first stress rupture loading condition of 1800°F and 40,000 pounds per square inch loading, specimens prepared by the present approach had an average life of 407 hours. Specimens prepared by the baseline approach wherein no carbon-containing layer at all was present, and consequently a substantial amount of SRZ was formed, had an average life of 251 hours. In a second stress rupture loading condition of 2000°F and 20,000 pounds per square inch loading, specimens prepared by the present approach had an average life of 341 hours, whereas specimens prepared by the baseline approach wherein no carbon-containing layer at all was present had an average life of 219 hours.

Specimens prepared by the present approach therefore tested superior to specimens where no carbon-containing layer was present and specimens prepared by the approach of the '263 patent.

For the sake of good order, various aspects of the invention are set out in the following clauses:-
1. A method for preparing a coated superalloy article (18), comprising the steps of
   furnishing a nickel-base superalloy substrate (34) having a composition which, when interdiffused with aluminum, forms a secondary reaction zone (46); and thereafter
   applying a protective coating structure (32) to a surface of the nickel-base superalloy substrate (34), the step of applying including the steps of
   placing the nickel-base superalloy substrate (34) into a deposition apparatus, thereafter
   depositing a carbon-containing layer (32) overlying and contacting the surface of the nickel-base superalloy substrate (34), and thereafter
   depositing an aluminum-containing layer (36) overlying and contacting the carbon-containing layer (32), wherein the step of depositing the aluminum-containing layer (36) is performed in the same deposition apparatus as the step of depositing the carbon-containing layer (32) and without exposing the nickel-base superalloy substrate (34) to an ambient atmospheric condition.
2. The method of clause 1, wherein the step of furnishing a nickel-base superalloy substrate (34) includes the step of furnishing the substrate (34) having a nominal composition, in weight percent, of about 16.5 percent cobalt, about 2 percent chromium, about 5.55 percent aluminum, about 8.25 percent tantalum, about 6 percent tungsten, about 5.95 percent rhenium, about 3 percent ruthenium, about 2 percent molybdenum, about 0.03 percent carbon, about 0.15 percent hafnium, about 0.004 percent boron, about 0.01 percent yttrium, balance nickel and minor elements.
3. The method of clause 1, wherein the step of furnishing a nickel-base superalloy substrate (34) includes the step of furnishing the substrate (34) having at least about 4 weight percent rhenium.
4. The method of clause 1, wherein the step of placing the nickel-base superalloy substrate (34) into a deposition apparatus includes the step of furnishing an electron-beam physical vapor deposition apparatus as the deposition apparatus.
5. The method of clause 1, wherein the step of placing the nickel-base superalloy substrate (34) into a deposition apparatus includes the step of furnishing a vacuum deposition apparatus as the deposition apparatus.
6. The method of clause 1, wherein the step of depositing the carbon-containing layer (32) includes the step of depositing the carbon-containing layer (32) as substantially pure carbon.
7. The method of clause 1, wherein the step of depositing the carbon-containing layer (32) includes the step of depositing the carbon in a form that is not chemically reacted with another element.
8. The method of clause 1, wherein the step of depositing the carbon-containing layer (32) includes the step of depositing the carbon-containing layer (32) to a thickness of from about 5 to about 15 micrometers.
9. The method of clause 1, wherein the step of depositing the aluminum-containing layer (36) includes the step of depositing the aluminum-containing layer (36) selected from the group consisting of a nickel aluminide overlay coating and an MCrAIX overlay coating.
10. The method of clause 1, including an additional step, after the step of depositing the aluminum-containing layer (36), of heat treating the substrate (34) with the carbon-containing layer (32) and the aluminum-containing layer (36) thereon at a temperature greater than about 1800°F.
11. The method of clause 1, including an additional step, after the step of depositing the aluminum-containing layer (36), of depositing a ceramic layer (44) overlying and contacting the aluminum-containing layer (36).
12. A method for preparing a coated superalloy article (18), comprising the steps of furnishing a nickel-base superalloy substrate (34) having a composition which, when interdiffused with aluminum, forms a secondary reaction zone (46), wherein the nickel-base superalloy substrate (34) has at least about 4 weight percent rhenium; and thereafter
   applying a protective coating structure (32) to a surface of the nickel-base superalloy substrate (34), the step of applying including the steps of
   placing the nickel-base superalloy substrate (34) into a vacuum deposition apparatus and evacuating the vacuum deposition apparatus, thereafter
   vacuum depositing a carbon-containing layer (80) contacting the surface of the nickel-base superalloy substrate (34), thereafter
   vacuum depositing an aluminum-containing layer (36) overlying and contacting the carbon-containing layer (32), wherein the step of depositing the aluminum-containing layer (36) is performed in the same deposition apparatus as the step of depositing the carbon-containing layer (32) and without exposing the nickel-base superalloy substrate (34) to an ambient atmospheric condition, and thereafter
   vacuum heat treating the substrate (34) with the carbon-containing layer (32) and the aluminum-containing layer (36) thereon at a temperature greater than about 1800°F.
13. The method of clause 12, wherein the step of furnishing a nickel-base superalloy substrate (34) includes the step of furnishing the substrate (34) having a nominal composition, in weight percent, of about 16.5 percent cobalt, about 2 percent chromium, about 5.55 percent aluminum, about 8.25 percent tantalum, about 6 percent tungsten, about 5.95 percent rhenium, about 3 percent ruthenium, about 2 percent molybdenum, about 0.03 percent carbon, about 0.15 percent hafnium, about 0.004 percent boron, about 0.01 percent yttrium, balance nickel and minor elements.
14. The method of clause 12, wherein the step of placing the nickel-base superalloy substrate (34) into a deposition apparatus includes the step of furnishing an electron-beam physical vapor deposition apparatus as the deposition apparatus.
15. The method of clause 12, wherein the step of depositing the carbon-containing layer (32) includes the step of depositing the carbon-containing layer (32) to a thickness of from about 5 to about 15 micrometers.
16. The method of clause 12, wherein the step of depositing the carbon-containing layer (32) includes the step of depositing the carbon-containing layer (32) to a thickness of from about 7.5 to about 15 micrometers.
17. The method of clause 12, wherein the step of depositing the aluminum-containing layer (36) includes the step of depositing the aluminum-containing layer (36) selected from the group consisting of a nickel aluminide and an MCrAIX.
18. The method of clause 12, including an additional step, after the step of depositing the aluminum-containing layer (36), of depositing a ceramic layer (44) overlying and contacting the aluminum-containing layer (36), wherein the step of depositing the ceramic layer (44) is performed in the same deposition apparatus as the step of depositing the carbon-containing layer (32) and the step of depositing the aluminum-containing layer (36), and without exposing the nickel-base superalloy substrate (34) to the ambient atmospheric condition.
19. The method of clause 12, including an additional step, after the step of depositing the aluminum-containing layer (36), of depositing a ceramic layer (44) overlying and contacting the aluminum-containing layer (36), wherein the step of depositing the ceramic layer (44) is performed in a different deposition apparatus than the step of depositing the carbon-containing layer (32) and the step of depositing the aluminum-containing layer (36).
20. A method for preparing a coated superalloy article (18), comprising the steps of
   furnishing a nickel-base superalloy substrate (34) having a composition which, when interdiffused with aluminum, forms a secondary reaction zone (46); and thereafter
   applying a protective coating structure (32) to a surface of the nickel-base superalloy substrate (34), the step of applying including the steps of
   depositing a carbon-containing layer (32) overlying and contacting the surface of the nickel-base superalloy substrate (34), and thereafter
   depositing an aluminum-containing layer (36) overlying and contacting the carbon-containing layer (32), wherein the substrate (34) is not exposed to the ambient environment between a beginning of the step of depositing the carbon-containing layer (32) and a completion of the step of depositing the aluminum-containing layer (36).

## Claims

1. A method for preparing a coated superalloy article (18), comprising the steps of
furnishing a nickel-base superalloy substrate (34) having a composition which, when interdiffused with aluminum, forms a secondary reaction zone (46); and thereafter
applying a protective coating structure (32) to a surface of the nickel-base superalloy substrate (34), the step of applying including the steps of
depositing a carbon-containing layer (32) overlying and contacting the surface of the nickel-base superalloy substrate (34), and thereafter
depositing an aluminum-containing layer (36) overlying and contacting the carbon-containing layer (32), wherein the step of depositing the aluminum-containing layer (36) is performed in the same deposition apparatus as the step of depositing the carbon-containing layer (32) and without exposing the nickel-base superalloy substrate (34) to an ambient atmospheric condition.

2. The method of claim 1, wherein the step of applying a protective coating structure (32) includes the step of lacing the nickel-base superalloy substrate (34) into a deposition apparatus.

3. The method of claim 1, wherein the step of furnishing a nickel-base superalloy substrate (34) includes the step of furnishing the substrate (34) having a nominal composition, in weight percent, of about 16.5 percent cobalt, about 2 percent chromium, about 5.55 percent aluminum, about 8.25 percent tantalum, about 6 percent tungsten, about 5.95 percent rhenium, about 3 percent ruthenium, about 2 percent molybdenum, about 0.03 percent carbon, about 0.15 percent hafnium, about 0.004 percent boron, about 0.01 percent yttrium, balance nickel and minor elements.

4. The method of claim 1, wherein the step of furnishing a nickel-base superalloy substrate (34) includes the step of furnishing the substrate (34) having at least about 4 weight percent rhenium.

5. The method of claim 1, wherein the step of placing the nickel-base superalloy substrate (34) into a deposition apparatus includes the step of furnishing an electron-beam physical vapor deposition apparatus as the deposition apparatus.

6. The method of claim 1, wherein the step of placing the nickel-base superalloy substrate (34) into a deposition apparatus includes the step of furnishing a vacuum deposition apparatus as the deposition apparatus.

7. The method of claim 1, wherein the step of depositing the carbon-containing layer (32) includes the step of depositing the carbon-containing layer (32) as substantially pure carbon.

8. The method of claim 1, wherein the step of depositing the carbon-containing layer (32) includes the step of depositing the carbon in a form that is not chemically reacted with another element.

9. The method of claim 1, wherein the step of depositing the carbon-containing layer (32) includes the step of depositing the carbon-containing layer (32) to a thickness of from about 5 to about 15 micrometers.

10. The method of claim 1, wherein the step of depositing the aluminum-containing layer (36) includes the step of depositing the aluminum-containing layer (36) selected from the group consisting of a nickel aluminide overlay coating and an MCrAIX overlay coating.

## Patentansprüche

1. Verfahren zum Herstellen eines beschichteten Superlegierungsgegenstandes (18), mit den Schritten:
Bereitstellen eines Superlegierungssubstrats (34) auf Nickelbasis mit einer Zusammensetzung, welche, wenn sie wechselseitig mit Aluminium diffundiert wird, eine sekundäre Reaktionszone (46) ausbildet; und danach
Aufbringen einer Schutzbeschichtungsstruktur (32) auf eine Oberfläche des Superlegierungssubstrats (34) auf Nickelbasis, wobei das Aufbringen die Schritte beinhaltet:
Abscheiden einer über der Oberfläche des Superlegierungssubstrat (34) auf Nickelbasis liegenden und damit in Kontakt stehenden kohlenstoffhaltigen Schicht (32), und danach
Abscheiden einer über der kohlenstoffhaltigen Schicht (32) und damit in Kontakt stehenden aluminiumhaltigen Schicht (36), wobei der Schritt der Abscheidung der aluminiumhaltigen Schicht (36) in derselben Abscheidungsvorrichtung wie der Schritt der Abscheidung der kohlenstoffhaltigen Schicht (32) und ohne Aussetzung des Superlegierungssubstrat (34) auf Nickelbasis an Umgebungsatmosphäre durchgeführt wird.

2. Verfahren nach Anspruch 1, wobei der Schritt der Aufbringung einer Schutzbeschichtungsstruktur (32) den Schritt der Platzierung des Superlegierungssubstrats (34) auf Nickelbasis in einer Abscheidungsvorrichtung beinhaltet.

3. Verfahren nach Anspruch 1, wobei der Schritt der Bereitstellung eines Superlegierungssubstrats (34) auf Nickelbasis den Schritt der Bereitstellung des Superlegierungssubstrats (34) auf Nickelbasis mit einer nominellen Zusammensetzung in Gewichtsprozent von etwa 16,5% Kobalt, etwa 2% Chrom, etwa 5,55% Aluminium, etwa 8,25% Tantal, etwa 6% Wolfram, etwa 5,95% Rhenium, etwa 3% Ruthenium, etwa 2% Molybdän, etwa 0,03% Kohlenstoff, etwa 015% Hafnium, etwa 0,004% Bor, etwa 0,01% Yttrium und der Rest Nickel und Spurenelemente umfasst.

4. Verfahren nach Anspruch 1, wobei der Schritt der Bereitstellung eines Superlegierungssubstrats (34) auf Nickelbasis den Schritt einer Bereitstellung des Superlegierungssubstrats (34) auf Nickelbasis mit wenigstens etwa 4 Gewichtsprozent Rhenium umfasst.

5. Verfahren nach Anspruch 1, wobei der Schritt der Platzierung des Superlegierungssubstrats (34) auf Nickelbasis in einer Abscheidungsvorrichtung den Schritt der Bereitstellung einer physikalischen Dampfabscheidungsvorrichtung mittels Elektronenstrahl als Abscheidungsvorrichtung beinhaltet.

6. Verfahren nach Anspruch 1, wobei der Schritt der Platzierung des Superlegierungssubstrats (34) auf Nickelbasis in einer Abscheidungsvorrichtung den Schritt der Bereitstellung einer Vakuumabscheidungsvorrichtung als Abscheidungsvorrichtung beinhaltet.

7. Verfahren nach Anspruch 1, wobei der Schritt der Abscheidung der kohlenstoffhaltigen Schicht (32) den Schritt der Abscheidung der kohlenstoffhaltigen Schicht (32) als im Wesentlichen reiner Kohlenstoff beinhaltet.

8. Verfahren nach Anspruch 1, wobei der Schritt der Abscheidung der kohlenstoffhaltigen Schicht (32) den Schritt der Abscheidung der kohlenstoffhaltigen Schicht (32) in einer Form beinhaltet, die nicht chemisch mit einem anderen Element reagiert.

9. Verfahren nach Anspruch 1, wobei der Schritt der Abscheidung der kohlenstoffhaltigen Schicht (32) den Schritt der Abscheidung der kohlenstoffhaltigen Schicht (32) bis zu eine Dicke von etwa 5 bis 15 µm beinhaltet.

10. Verfahren nach Anspruch 1, wobei der Schritt der der Abscheidung der aluminiumhaltigen Schicht (36) den Schritt der Abscheidung der aluminiumhaltigen Schicht (36) beinhaltet, die aus der aus einer Nickelaluminid-Überzugsbeschichtung und einer MCrAlX-Überzugsbeschichtung bestehenden Gruppe ausgewählt wird.

## Revendications

1. Procédé de préparation d'un article en superalliage revêtu (18) comprenant les étapes suivantes :
utilisation d'un substrat en superalliage à base de nickel (34) dont la composition, après interdiffusion avec de l'aluminium, forme une zone de réaction secondaire (46) ;
puis application d'une structure de revêtement protecteur (32) sur une surface de substrat en superalliage à base de nickel (34), ladite étape d'application comprenant les étapes suivantes :
dépôt d'une couche contenant du carbone (32) couvrant et touchant la surface du substrat en superalliage à base de nickel (34)
puis dépôt d'une couche contenant de l'aluminium (36) couvrant et touchant la couche contenant du carbone (32), l'étape de dépôt de la couche contenant de l'aluminium (36) ayant lieu dans le même appareil de dépôt que l'étape de dépôt de la couche contenant du carbone (32), et sans exposition du substrat en superalliage à base de nickel (34) aux conditions atmosphériques ambiantes.

2. Procédé selon la revendication 1, **caractérisé en ce que** l'étape d'application d'une structure de revêtement (32) comprend l'étape de placement du substrat en superalliage à base de nickel (34) dans un appareil de dépôt.

3. Procédé selon la revendication 1, **caractérisé en ce que** l'étape d'utilisation d'un substrat en superalliage à base de nickel (34) comprend l'étape d'utilisation du substrat (34) de composition pondérale nominale correspondant à 16,5 % de cobalt environ, à 2 % de chrome environ, à 5,55 % d'aluminium environ, à 8,25 % de tantale environ, à 6 % de tungstène environ, à 5,95 % de rhénium environ, à 3 % de ruthénium environ, à 2 % de molybdène environ, à 0,03 % de carbone environ, à 0,15 % de hafnium environ, à 0,004 % de bore environ, à 0,01 % d'yttrium environ, le reste étant du nickel et des éléments à l'état traces.

4. Procédé selon la revendication 1, **caractérisé en ce que** l'étape d'utilisation d'un substrat en superalliage à base de nickel (34) comprend l'étape d'utilisation du substrat (34) contenant au moins à peu près 4 % de rhénium en poids.

5. Procédé selon la revendication 1, **caractérisé en ce que** l'étape de placement du substrat en superalliage à base de nickel (34) dans un appareil de dépôt comprend l'étape d'utilisation d'un appareil de dépôt physique en phase vapeur par faisceau électronique en tant qu'appareil de dépôt.

6. Procédé selon la revendication 1, **caractérisé en ce que** l'étape de placement du substrat en superalliage à base de nickel (34) dans un appareil de dépôt comprend l'étape d'utilisation d'un appareil de dépôt sous vide en tant qu'appareil de dépôt.

7. Procédé selon la revendication 1, **caractérisé en ce que** l'étape d'application de la couche contenant du carbone (32) comprend l'étape de dépôt de la couche contenant du carbone (32) sous forme de carbone pratiquement pur.

8. Procédé selon la revendication 1, **caractérisé en ce que** l'étape d'application de la couche contenant du carbone (32) comprend l'étape de dépôt du carbone sous une forme qui ne réagit pas chimiquement avec un autre élément.

9. Procédé selon la revendication 1, **caractérisé en ce que** l'étape d'application de la couche contenant du carbone (32) comprend l'étape de dépôt de la couche contenant du carbone (32) jusqu'à une épaisseur comprise entre 5 et 15 micromètres.

10. Procédé selon la revendication 1, **caractérisé en ce que** l'étape de dépôt de la couche contenant de l'aluminium (36) comprend l'étape de dépôt de la couche contenant de l'aluminium (36) choisie parmi les revêtements suivants : revêtement couvrant d'aluminure de nickel et revêtement couvrant à base de MCrAIX.
